(19) Europäisches Patentamt
European Patent Office
Office européen des brevets

(11) EP 1 768 465 B1

(12) EUROPEAN PATENT SPECIFICATION

(45) Date of publication and mention of the grant of the patent:
**16.12.2009 Bulletin 2009/51**

(51) Int Cl.:
***H05B 33/14*** *(2006.01)* ***C08F 38/00*** *(2006.01)*
***C09K 11/06*** *(2006.01)*

(21) Application number: **06019652.4**

(22) Date of filing: **27.04.2001**

(54) **Organic luminous material and organic light-emitting device**

Organischer lumineszenter Stoff und organisches lichtemittierendes Bauelement

Matière organique lumineuse et dispositif organique émetteur de lumière

(84) Designated Contracting States:
**DE FR GB NL**

(30) Priority: **27.04.2000 JP 2000128364**
**22.09.2000 JP 2000288692**
**24.04.2001 JP 2001125359**

(43) Date of publication of application:
**28.03.2007 Bulletin 2007/13**

(62) Document number(s) of the earlier application(s) in accordance with Art. 76 EPC:
**01303861.7 / 1 158 839**

(73) Proprietor: **Fujitsu Ltd.**
**Kawasaki-shi, Kanagawa 211-8588 (JP)**

(72) Inventors:
- **Yoshikawa, Kota**
  **Fujitsu Limited**
  **Kawasaki-shi**
  **Kanagawa 211-8588 (JP)**
- **Kijima, Masashi**
  **Tsukuba-shi**
  **Ibaraki (JP)**
- **Shirakawa, Hideki**
  **Yokohama-shi**
  **Kanagawa (JP)**
- **Kinoshita, Ikuo**
  **Tsukuba-shi**
  **Ibaraki (JP)**

(74) Representative: **Fenlon, Christine Lesley**
**Haseltine Lake LLP**
**Lincoln House, 5th Floor**
**300 High Holborn**
**London WC1V 7JH (GB)**

(56) References cited:
**EP-A- 0 243 807 DE-A1- 4 339 646**

- **T. OGAWA: "Diacetylenes in polymer systems" PROG. POLYM. SCI., vol. 20, 1995, pages 943-985, XP002415751**
- **X.T. TAO ET.AL.: "Novel main-chain poly-carbazoles as hole and electron transport materials in polymer light-emitting diodes" APPL. PHYS. LETT., vol. 71, no. 14, 1997, pages 1921-1923, XP002339411**
- **REMMERS M ET AL: "THE OPTICAL, ELECTRONIC, AND ELECTROLUMINESCENT PROPERTIES OF NOVELPOLY(P-PHENYLENE)-RELATED POLYMERS" MACROMOLECULES, AMERICAN CHEMICAL SOCIETY. EASTON, US, vol. 29, no. 23, 4 November 1996 (1996-11-04), pages 7432-7445, XP000631108 ISSN: 0024-9297**
- **PATENT ABSTRACTS OF JAPAN vol. 016, no. 273 (C-0953), 18 June 1992 (1992-06-18) & JP 04 068002 A (ASAHI CHEM IND CO LTD), 3 March 1992 (1992-03-03)**
- **YANG M ET AL: "Characterization and fluorescence properties of thiophene-modified pi-conjugated nickel poly-yne polymers" POLYMER, ELSEVIER SCIENCE PUBLISHERS B.V, GB, vol. 40, no. 11, May 1999 (1999-05), pages 3203-3209, XP004157673 ISSN: 0032-3861**
- **HOLZER W ET AL: "Excitation intensity-dependent fluorescence behaviour of some luminescent polymers" POLYMER, ELSEVIER SCIENCE PUBLISHERS B.V, GB, vol. 39, no. 16, July 1998 (1998-07), pages 3651-3656, XP004120980 ISSN: 0032-3861**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



(Cont. next page)

- T. HATTORI ET.AL.: "Photoinduced absorption and luminescence in polydiacetylenes" J.PHS.C: SOLID STATE PHYS., vol. 17, 1984, pages L881-L888, XP002339413

## Description

The present invention relates to an organic luminous material and an organic light-emitting device and, more particularly, to an organic light-emitting device like an organic electroluminescence (EL) device employing such material. ,

In recent years, the research and development of an organic EL device applied to a flat display panel, a mobile display device, etc. has been vigorously pursued. A display device employing an organic EL device can provide high brightness and full color display by low voltage driving.

In addition, a display device consisting of an organic EL devices has features different from a liquid crystal display (LCD). For example, there can be provided a light weight and low cost product that has no viewing angle dependence because it its a spontaneously emissive display, does not need back lights because of the high contrast, has a quick response speed, has an easy film formation characteristic, and withstands impact since the overall device is constructed from solid state elements.

An organic EL device has a structure made up of lower electrode formed of transparent conductive material, an organic thin film (luminous layer), and an upper electrode formed of magnesium, potassium, etc. formed in sequence on the glass substrate, for example. The thickness of the overall structure can be reduced up to about several mm. Then, light is emitted from the luminous layer by applying a DC voltage between the lower electrode and the upper electrode, and this light is passed through the lower electrode and the glass substrate to output to the outside. The organic EL device is an injection electroluminescence device that increases the number of carriers in operation by injecting the carriers from the electrode to thus emit light by recombination. Sometimes the organic EL device is also called an organic LED.

As the luminous material employed in the organic thin film of the organic EL device, there are used monomer materials and polymer materials. Normally a film of monomer material is formed by the vacuum evaporation method, and normally a film of polymer material is formed by a coating method. Coating methods are practical in device formation because expensive equipment is not needed.

JP04068002A discloses a diacetylene polymer comprising repeating units of formula I

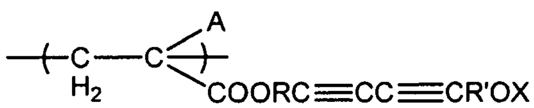

I

wherein A is hydrogen or methyl; X is hydrogen or 1-6 C monovalent hydrocarbyl; and R and R' are each 1-6 C bivalent hydrocarbyl.

"Synthesis, Optical Absorption, Fluorescence, Quantum Efficiency, and Electrical Conductivity Studies of Pyridine/Pyridinium Dialkynyl Organic and Pt (II)-σ-Acetylide Monomers and Polymers" by Kevin A. Bunten and Ashok K. Kakkar, Macromolecules 1996, 29. 2885-2893, discloses the synthesis of a variety of 2.5- and 2.6-diethynylpyridine based organic and $pt^{II}$-σ-acetylide monomers and polymers. Quarternization of pyridine nitrogen via solution nucleophilic substitution reactions with methyl iodide and methyl triflates is said to yield stable pyridinium analogs, accompanied by strong red shifts in the UV-vis absorption spectra.

It is known to employ PPV (poly p-phenylenevinylene) as the polymer material. An EL device employing such material is set forth in Patent Application Publication (KOKAI) Hei 10-326675, for example.

A conjugated polymer material such as PPV employed as the luminous layer in the prior art is in a highly crystalline state at normal temperature, unlike a normal polymer material.

Accordingly, if such conjugated polymer material is formed on the substrate, unevenness readily occurs on the surface of the luminous layer made of the polymer.

If a voltage is applied between the lower electrode and the upper electrode under conditions such that unevenness is present on the surface of the luminous layer, the electric field is readily concentrated in the concave portion of the surface of the luminous layer. Thus, there is the possibility that the luminous layer is destroyed by the electric field, and then a short-circuit is caused between the lower electrode and the upper electrode.

Also, since the luminous polymer layer in the prior art, which is readily crystallised, is insoluble in the organic solvent, treatment must be applied, e.g., the polymer must be mixed into the organic solvent while being heated, when the polymer is coated on the substrate, and thus it is not easy to handle the polymer. In addition, even if the conjugated polymer in the prior art is dissolved in the organic solvent, such polymer is still readily crystallized after cooling.

It is an object of the present invention to provide a light-emitting device having a luminous layer formed of polymer material that can be highly planarized and has a solubility in organic solvents higher than that of polymer film material in the

prior art.

According to a first aspect of the present invention, there is provided an organic luminous material having the general formula

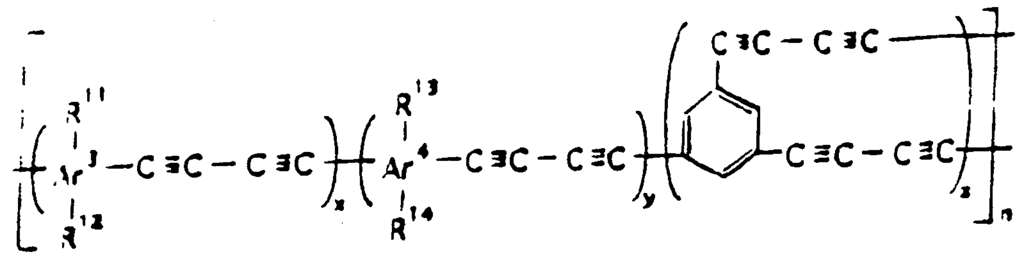

(1)

where $Ar^3$ denotes a first arylene group, $Ar^4$ denotes a second arylene group, $R^{11}$, $R^{12}$, $R^{13}$ and $R^{14}$ are substituents which can be the same or different or some of which can be the same and other(s) different, x, y, z denote copolymerization ratios and n denotes the degree of polymerisation;
wherein $0<x<1$, $0<y<1$, $0<z<1$ and $x+y+z=1$.

Luminous material according to the present invention can emit light in the blue or near blue color wavelength band.

The aromatic rings constituting the first and second arylene groups can be any one of benzene, pyrrole, thiophene, carbazole, furan, fluorene, naphthalene, anthracene, and derivatives thereof.

The respective substituents $R^{11}$, $R^{12}$, $R^{13}$ and $R^{14}$ can be any one of hydrogen, alkyl, alkoxy, carboxyl, cyano, phenyl, biphenyl, and cyclohexylphenyl.

According to a second aspect of the present invention there is provided an organic light-emitting device comprising: a lower electrode; a luminous layer formed on the lower electrode, which is the organic luminous material embodying the first aspect of the present invention; and an upper electrode formed on the luminous layer.

For a better understanding of the invention, and to show how the same may be carried into effect, reference will now be made, by way of example, to the accompanying drawings, in which:-

FIG.1 is a graph showing the fluorescent spectrum of a blue color luminous layer employed in an organic EL device according to a fourth embodiment of the present invention.

In order to display a full color image on the organic EL display device, a polymer that can emit blue color light is required. Therefore, a polymer that can emit light in the blue color wavelength band will be explained hereunder.

A copolymerized polymer providing a blue color luminous layer has, for example, the structure of formula (2). The spectrum of the polymer given by the formula (2) is shown in FIG. 1 and has peaks at 405 nm, 495 nm, and 512 nm in the luminous wavelength band. In the chemical formula. x : y : z is 6 : 3 : 1.

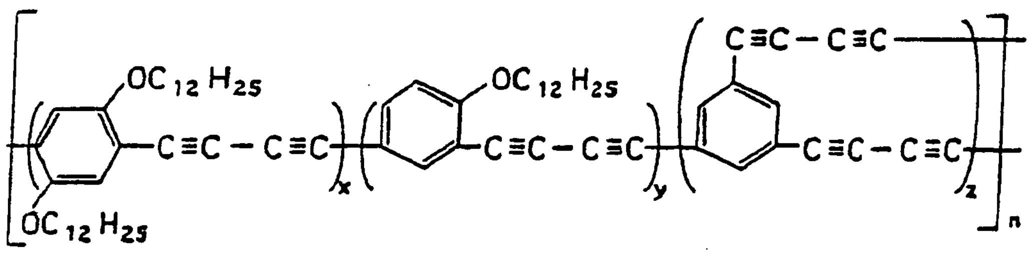

(2)

The polymer given by the chemical formula (25) is synthesised as follows.

First, a catalyst solution is formed by supplying oxygen to a reaction solution in which 10 mg (O.1 mmol) of copper (I) chloride, 12 mg (O. 1 mmol) of TMEDA, and 20 ml of THF are mixed. Then, 297 mg (0.6 mmol) of 2,5-didodecyloxy-p-diethynylbenzene, 93 mg (0.3 mmol) of 4-dodecyloxy-m-diethynylbenzene, and 15 mg (0.1 mmol) of 1,3,5-triethynylbenzene are added to THF and this solution is added to the above catalyst solution, and then the resultant

solution is stirred under an oxygen atmosphere for two days.

Reaction (3) then takes place.

The reaction solution is then dropped into 500ml of 2-normal methanol hydrochloride, and the resultant precipitate is recovered. Then, this precipitate is dissolved in chloroform, the insoluble component is removed from this solution and the solution is dropped into 500 ml of methanol, and then the resultant precipitate is recovered, 304g of a yellow powder are obtained as a yield of 75.4 %.

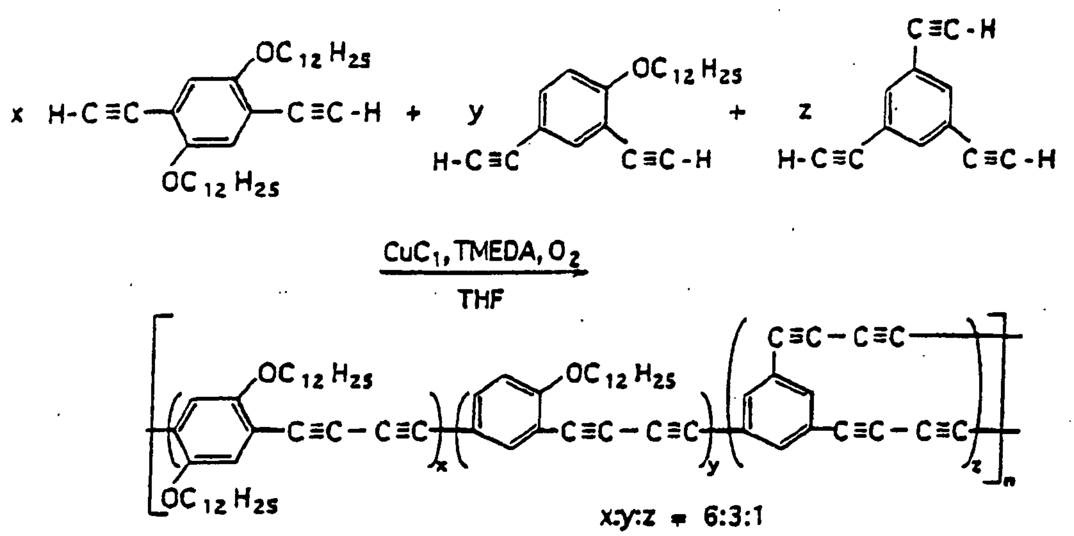


(3)

The general formula of the copolymerized polymer according to the present invention, that emits light in the blue and near blue color wavelength band, is expressed by the formula (4). In the formula (4), $Ar^3$ and $Ar^4$ both denote an arylene group (dihydric aromatic ring). The aromatic ring providing the arylene group can be a benzene, pyrrole, thiophene, carbazole, furan, fluorene, naphthalene, or anthracene ring or a derivative thereof.

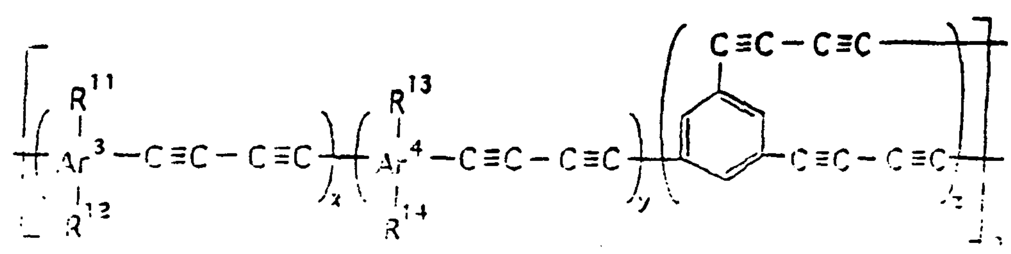

(4)

In general, the arylene group can be, for example, biphenyl, terphenyl, perylene, coumarin, diphenylamine, triphenylamine, phenanthrene, phenanthridine, phenanthroline, phenylazobenzene, anthraquinone, acridinone, quinacridone, stilbene or a derivative thereof.

$R^{11}$, $R^{12}$, $R^{13}$, $R^{14}$ are substituents which can be the same or different and can be hydrogen, alkyl, alkoxy, carboxyl, cyano, phenyl, biphenyl or cyclohexylphenyl.

In addition, $R^{11}$, $R^{12}$, $R^{13}$, $R^{14}$ can all be different types, or some of them are the same types, or $R^{11}$, $R^{12}$ $R^{13}$, $R^{19}$ are all same types. x, y, z denote the copolymerization ratio, and n denotes the degree of polymerization.

As described above, according to the present invention; a luminous layer made of the polymer of formula (4) is formed between the lower electrode and the upper electrode. In contrast to the polymers employed as the luminous layer in the prior art, such polymer is hard to crystallize at ambient temperature and has a high solubility in solvents.

Accordingly, if this polymer is employed as the luminous layer, planarization of the luminous layer can be

facilitated, short-circuiting between the upper electrode and the lower electrode hardly occurs, and the yield of the device can be improved.

## Claims

**1.** An organic luminous material having the general formula

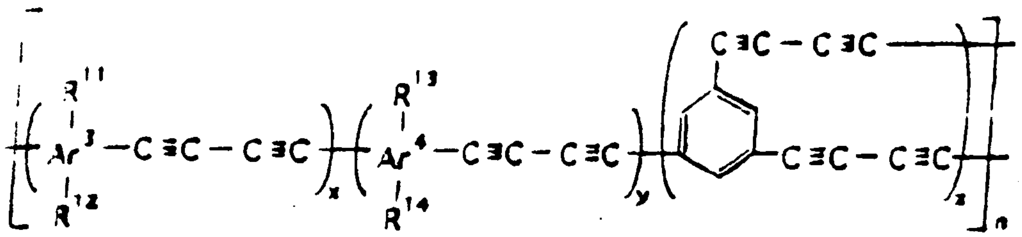

(1)

where $Ar^3$ denotes a first arylene group, $Ar^4$ denotes a second arylene group, $R^{11}$, $R^{12}$, $R^{13}$ and $R^{14}$ are substituents which can be the same or different or some of which can be the same and other(s) different, x, y, z denote copolymerization ratios and n denotes the degree of polymerisation;
wherein $0<x<1$, $0<y<1$, $0<z<1$ and $x+y+z=1$

**2.** An organic luminous material according to claim 1, wherein the aromatic rings constituting the first and second arylene groups are the same or different and selected from benzene, pyrrole, thiophene, carbazole, furan, fluorene, naphthalene and anthracene and derivatives thereof.

**3.** An organic luminous material according to claim 1 or 2, wherein the said substituents are selected from hydrogen, alkyl, alkoxy, carboxyl, cyano, phenyl, biphenyl and cyclohexylphenyl.

**4.** An organic light-emitting device comprising:

a lower electrode;
a luminous layer formed on the lower electrode, which is the organic luminous material as claimed in any one of claims 1 to 3; and
an upper electrode formed on the luminous layer.

## Patentansprüche

**1.** Organisches Leuchtmaterial mit der allgemeinen Formel

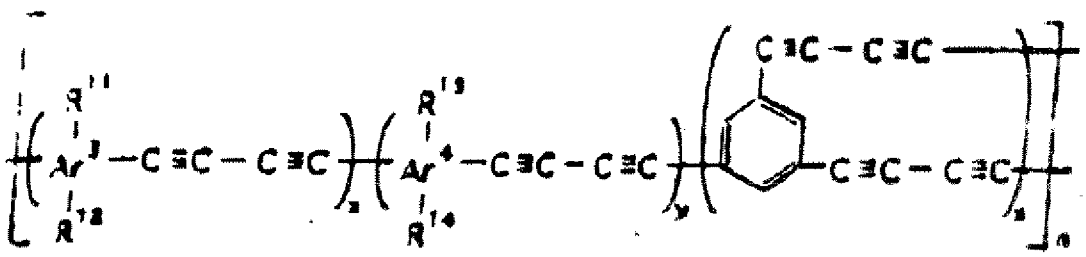

(1)

wobei $Ar^3$ eine erste Arylengruppe bezeichnet, $Ar^4$ eine zweite Arylengruppe bezeichnet, $R^{11}$, $R^{12}$, $R^{13}$ und $R^{14}$ Substituenten sind, die die gleichen oder verschieden sein können oder von denen einige die gleichen und ein anderer (andere) verschieden sein können, x, y, z Copolymerisationsverhältnisse bezeichnen und n den Polymerisationsgrad bezeichnet;
bei dem $0<x<1$ $0<y<1$, $0<z<1$ und $x+y+z=1$ ist.

**2.** Organisches Leuchtmaterial nach Anspruch 1, bei dem die aromatischen Ringe, die die ersten und zweiten Arylendgruppen bilden, die gleichen oder verschieden sind und ausgewählt sind aus Benzol, Pyrrol, Thiophen, Carbazol, Furan, Fluoren, Naphthalin und Anthracen und Derivaten derselben.

3. Organisches Leuchtmaterial nach Anspruch 1 oder 2, bei dem die genannten Substituenten ausgewählt sind aus Wasserstoff, Alkyl, Alkoxy, Carboxyl, Cyan, Phenyl, Biphenyl und Cyclohexylphenyl.

4. Organische lichtemittierende Vorrichtung mit:

einer unteren Elektrode;
einer Leuchtschicht, die auf der unteren Elektrode gebildet ist und das organische Leuchtmaterial nach einem der Ansprüche 1 bis 3 ist; und
einer oberen Elektrode, die auf der Leuchtschicht gebildet ist.

## Revendications

1. Matériau lumineux organique ayant la formule général :

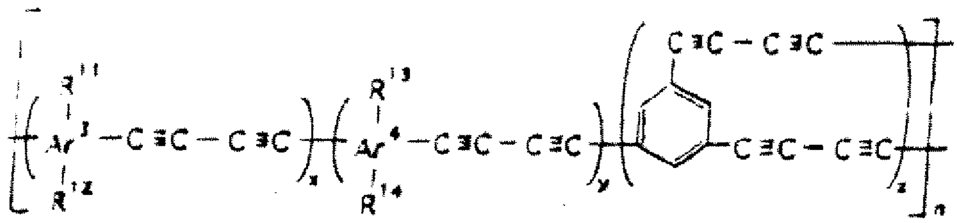
(I)

où $Ar^3$ désigne un premier groupe arylene, $Ar^4$ désigne un deuxième groupe arylène, $R^{11}$, $R^{12}$, $R^{13}$ et $R^{14}$ sont des substituents qui peuvent être identiques ou différents ou dont certains peuvent être identiques est le ou les autres différents, x, y et z désignent des rapports de copolymérisation, et n désigne le degré de polymérisation;
avec

$$0 < x < 1, 0 < y < 1, 0 < z < 1 \text{ et } x + y + z = 1.$$

2. Matériau lumineux organique selon la revendication 1, dans lequel les noyaux aromatiques constituant les premier et deuxième groupes arylènes sont identiques ou différents et sont choisis parmi le benzène, le pyrrole, le thiophène, le carbazole, le furanne, le fluorène, le naphtalène et anthracène, et leurs dérives.

3. Matériau lumineux organique selon la revendication 1, dans lequel lesdits substituants sont choisis parmi l'atome d'hydrogène, les groupes alkyle, alcoxy, carbonyle, cyano, phényle, biphényle et cyclohexylphényle.

4. Dispositif électroluminescent organique comprenant :

une électrode inférieure ;
une couche lumineuse formée sur l'électrode inférieure, qui est le matériau lumineux organique selon l'une quelconque des revendications 1 à 3 : et
une électrode supérieure formée sur la couche lumineuse.

FIG. 1

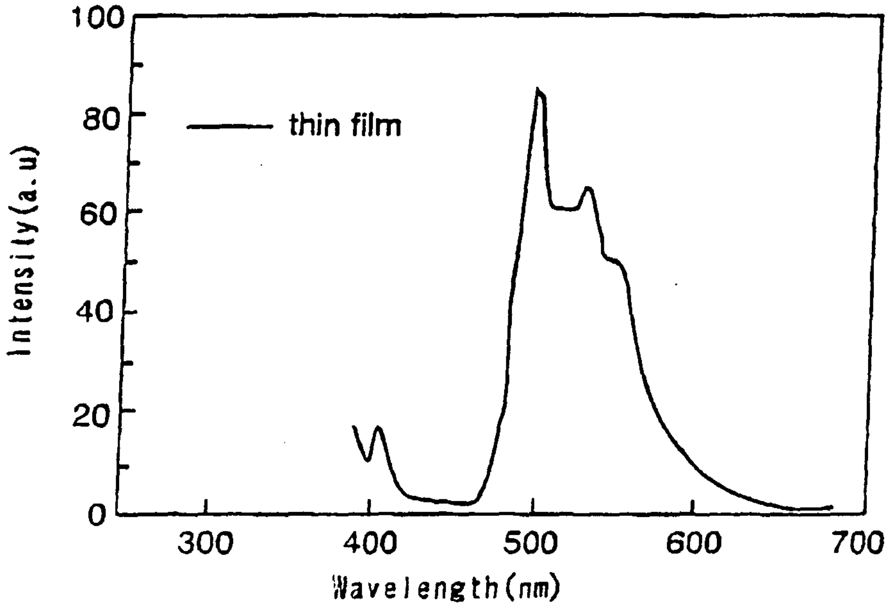
100
80
60
40
20
0
300
400
500
600
700
Intensity(a.u)
Wavelength(nm)
thin film

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 04068002 A
- JP HEI10326675 B


### Non-patent literature cited in the description


- **Kevin A. Bunten ; Ashok K. Kakkar.** Synthesis, Optical Absorption, Fluorescence, Quantum Efficiency, and Electrical Conductivity Studies of Pyridine/Pyridinium Dialkynyl Organic and Pt (II)-σ-Acetylide Monomers and Polymers. *Macromolecules,* 1996, vol. 29, 2885-2893